# EUROPEAN PATENT SPECIFICATION

(11) **EP 1 991 716 B1**
(45) Date of publication and mention of the grant of the patent: **21.09.2011**
(21) Application number: 07712590.4
(22) Date of filing: 23.02.2007
(51) Int. Cl.: C23C 14/28

(54) **ELEMENT**
ELEMENT
ÉLÉMENT

(30) Priority: 23.02.2006 FI 20060177; 23.02.2006 FI 20060182; 12.04.2006 FI 20060357
(43) Date of publication of application: 19.11.2008
(73) Proprietor: Picodeon Ltd Oy, 00120 Helsinki (FI)
(72) Inventor: LAPPALAINEN, Reijo, FI-70870 Hiltulanlahti (FI); RUUTTU, Jari, FI-10330 Billnäs (FI); MYLLYMÄKI, Vesa, FI-00200 Helsinki (FI); YLÄTALO, Sampo, FI-00660 Helsinki (FI); MÄKITALO, Juha, FI-10600 Tammisaari (FI); PULLI, Lasse, FI-00670 Helsinki (FI)
(74) Representative: Brax, Matti Juhani
(86) International application number: PCT/FI2007/000048
(87) International publication number: WO 2007/096463

(56) References cited:
- EP-A- 0 819 782
- EP-A1- 0 731 189
- WO-A-03/055636
- US-A- 5 368 681
- US-A- 5 538 767
- US-A- 5 760 366
- US-A1- 2002 004 266
- US-A1- 2002 081 397
- US-A1- 2005 276 931

## Description

On a very general level the invention pertains to surface structures, but more particularly to surface structures which can produce a heat effect. The invention also pertains to the use of an element, as defined in the claim 13 directed to the use. The invention also pertains to a window structure, as defined in preamble of the claim 19 directed thereto.

Heating elements as such are needed in many places, both in industry and in households. A fairly common problem is to generate a suitable temperature for a particular purpose. For example, chemical reactions occur faster at a certain first temperature than at a certain second temperature. In addition, the occurrence or non-occurrence of phase transitions of various substances often depends on the temperature in a manner characteristic to the substance in question.

Generation of heat by burning or producing a cooling effect by means of ice, for example, are a couple of known techniques. However, after the invention of eclectricity, electric heaters have been a convenient way of achieving temperature changes. In addition, using a conventional Peltier element, for instance, it is possible to utilize electricity in order to maintain a temperature lower than the ambient temperature - e.g. to keep cool a pitcher of milk in a restaurant.

The fact is, however, that almost without exception a conductor or at least a transformer containing conductors is needed for the transmission of electricity. The existence of the conductors, necessary as such, will then be problematic especially in applications in which transparent surfaces are to be heated.

Anyone who has driven an automobile in snowy winter conditions knows that the car windows may in certain circumstances become frosty and/or foggy. Furthermore, formation of ice on ailerons of an airplane during a flight may have disastrous consequences.

Electric conductors can be used to supply electricity to a heating element in the rear window of a car, for instance, where resistor wires heat the glass. Similar conductors or wires can be installed in the wing of an airplane, but in the case of a car the visibility through the heated glass is poor in a sense. On the other hand, even if the wires were thin, they cannot be used in the windscreen and/or side windows because of safety reasons. Techniques are known to exist for the manufacture of heated mirrors, but those techniques which are suitable for mirrors are not suitable, at least as such, for realizing transparent structures, which is expected of a window structure. Conductors e.g. in the windscreen of a car create both a visual and an esthetic impediment. At high velocities wires on a wing or fuselage of an airplane may also affect the aerodynamics through the flow along the surface of the wing.

In an airplane or other aircraft the metal wires of the heaters may weigh quite a lot, which means increased fuel consumption because of a bigger take-off/flying weight. If, however, the elements are made smaller and thus lighter, this also means a lower heating power and, hence, even longer heat-up times. Furthermore, unpleasant surprises in the form of freezing in the wings during flights may occur more easily when there is less heating power available. For safety reasons, no pilot wants to count heater wires on the cockpit window.

Recent major developments in laser technology have provided means to be used in high-power laser systems based on semiconductor fibers, supporting the development of methods based on cold ablation.

However, fibers in the conventional fiber lasers do not allow high-power use, where pulsed laser radiation is transmitted through a fiber to the work spot, at a sufficient net power. At the necessary power level in the work spot the conventional fibers will not tolerate the radiation transmission loss caused by absorption. One reason to use fiber technology in the transmission of laser radiation from the source to the target has been that the transmission of even one single beam through the open air is a reasonable risk for the workers in an industrial working environment and also very challenging if not even impossible on an industrial scale.

At the priority date of the present application purely fiber-based diode-pumped semiconductor lasers are competing with lamp-pumped ones, both being such that a laser beam is first conducted into the fiber and then further to the target at the work spot. These fiber laser systems are the only ones suitable for laser ablation applications of an industrial scale.

The current fibers in fiber lasers and, consequently, the low radiation power restrict the use of fiber materials in the vaporization/ablation of target materials. Aluminum can be vaporized/ablated by low-power pulses, whereas materials harder to vaporize/ablate, such as copper, tungsten etc., need more power per pulse. The same applies in situations where the aim is to produce new compounds using the same known technique. Notable examples include fabrication of diamond directly from carbon, or production of aluminum oxide directly from aluminum and oxygen through an appropriate gas phase reaction in post-laser ablation conditions.

On the other hand, one of the most significant obstacles to the development of fiber laser technology seems to be the capacity of the fiber to tolerate high-power laser pulses without the fiber being damaged or the quality of the laser beam being degraded.

Using the new cold ablation to solve the problems of both quality and production rate in connection with coatings, thin film production and cutting/grooving/engraving etc., the main approach has been to increase the laser power and diminish the spot size of the laser beam on the target surface. Most of the power was, however, wasted on noise. The quality and production rate problems remained unsolved even though some laser manufacturers solved problems related to laser power. It has not been possible to produce representative samples of both coatings/thin films and cutting/grooving/engraving other than at a low repetition frequency, narrow scanning width and long machining time, which as such are outside of industrial feasibility, and especially so in the case of large objects.

The pulse energy content is such that as the pulse power gets higher and the duration shorter, the significance of the problem grows with respect to laser pulses of a shorter duration. Problems occur to a significant extent even with nanosecond pulse lasers even though they are not suitable as such to cold ablation methods.

Shortening the pulse duration to the femtosecond or attosecond range makes the problem almost unsolvable. For example, in a picosecond laser system with a pulse duration of 10 to 15 ps, the pulse energy should be 5 µJ for a 10-to-30-µm spot, when the total power of the laser is 100 W and repetition frequency 20 MHz. The author, at the priority date of the present application, has no knowledge of a fiber that could withstand such a pulse power.

The shorter the pulse, the higher the energy per given time to be conducted through the fiber across a certain cross section of the fiber. In conditions such as described above, as regards pulse duration and laser power, the level of an individual pulse may correspond to a power of 400 kW, approximately. As far as the author knows, it has not been possible, up to the priority date of the present application, to manufacture a fiber which could withstand even 200 kW and allow a 15-ps pulse to go through without distortions from the optimum pulse shape.

If we do not want to limit the possibilities of plasma production from any available material, the pulse power level must be freely selectable, e.g. between 200 kW and 80 MW. The problems related to the limitations of present-day fiber lasers arise not only from the fiber itself, but are also associated with the coupling together, through optical couplers, of separate diode-pumped lasers when attempting to achieve a desired total power. Such a combined beam has been conducted in a single fiber to the work spot using conventional technology.

Consequently, optical couplers should withstand at least as much power as the fiber itself when used in the transmission path for transmitting high-power pulses to the work spot. Even when using ordinary power levels, the manufacture of suitable optical couplers is very expensive, their operation uncertain in a sense, and they will wear out in use so that they will have to be replaced after a certain period of time.

The yield is directly proportional to the repetition frequency or rate. On the other hand, known mirror film scanners (i.e. galvano-scanners or other scanners of the similar back-and-forth-oscillating type) have a duty cycle characterized by a back-and-forth oscillating motion so that the stopping of the mirror at the ends of the duty cycle is somewhat problematic, just like the acceleration and deceleration related to the turning point and the momentary stop associated with it, which affect the usefulness of such a mirror as a scanner, but especially affect the scanning width, too. If one attempts to scale up the yield by increasing the repetition frequency, the accelerations and decelerations will result in either a narrow scanning area or an uneven distribution of radiation and thus also of plasma at the target when the radiation hits the target via a mirror which is decelerating and/or accelerating.

If one attempts to raise the production rate of the coating/thin film simply by increasing the pulse repetition frequency, the above-mentioned known scanners will direct pulses on overlapping spots in the target area already at low pulse frequencies in the kHz region in an uncontrollable manner.

The same problem applies to nanosecond lasers but is even more serious because the pulses have high energies and long durations. Therefore, even a single nanosecorid-range pulse will cause considerable erosion in the target material.

In known techniques the target not only may become unevenly worn out but can easily be fragmented in a manner which degrades the quality of the plasma. Therefore, a surface coated using such a technique also suffers from detrimental plasma-related problems. There may be fragments on the surface, the plasma may be unevenly distributed, thus also forming an unevenly distributed surface, etc., which are problematic matters in applications requiring accuracy, but not necessarily problematic in paint or pigment applications in which the disadvantages remain below the application-specific detection threshold. Current methods use the target only once so that the same target cannot be re-used at the same surface. Attempts have been made to solve the problem by using only virginal target surface by moving the target and/or the spot of the beam relative to each other as required.

In machining or working type applications the leftovers or surplus which contain fragments may also result in an uneven and thus bad cut line, as could happen in cases involving bores related to flow control. Furthermore, surfaces may be left with an uneven appearance due to the released fragments, which is not appropriate e.g. in the manufacture of certain semiconductors.

In addition, the back-and-forth movement of mirror film scanners results in inertia which causes stress in the structure itself but also where such a mirror is attached through a bearing for moving the mirror. Such inertia may gradually loosen the mirror attachment, especially if such a mirror were in operation at an extreme end of its settings, and may also result in the drifting of the settings in the long run, which may manifest itself as uneven repeatability of product quality. Because of the stops and the variations of direction and velocity of the movement, such a mirror film scanner has a very limited scanning width to be used in ablation and plasma production. Effective production cycle relative to the total production cycle length is short, even if the operation were slow in the first place. From the point of view of production increase a system which uses mirror film scanners is inevitably slow from the plasma production standpoint, narrow in its scanning width, unstable in the long term, but has a very high probability of running into detrimental particle emissions in the plasma, resulting in corresponding characteristics in the machining and/or coating products using it.

Fiber laser technology is also associated with problems such as that no large amounts of energy can be transmitted through the fiber without the fiber melting and/or disintegrating or the quality of the propagating beam deteriorating because of the degeneration of the fiber due to the high power of the energy traveling through it. Already a 10-µJ pulse power may damage the fiber if it has even a small weakness in the structure or quality. In fiber-based technology, fiber-optic couplers, which e.g. combine together a number of laser power sources such as diode pumps, are especially susceptible to damage.

The shorter the pulse, the higher the power per same amount of energy, so the problem is emphasized when the laser pulse is shortened to deliver the same amount of energy. Especially in nanosecond lasers the problem is already quite significant.

When the pulse duration is shortened down to the femtosecond or even attosecond range, the problem becomes nigh insoluble. For example, in a picosecond laser system with a pulse duration of 10 to 15 ps, the pulse energy should be 5 µJ for a 10-to-30-µm spot, when the total power of the laser is 100 W and repetition frequency 20 MHz. At the priority date of the present application the author is not aware of a fiber that could withstand a pulse like that.

In laser ablation, which is an important field of fiber laser applications, it is quite important to achieve a maximal and optimal pulse power and energy. Considering a situation where the pulse length is 15 ps and pulse energy is 5 µJ and total power 1000 W, the power level of the pulse is about 400,000 W (400 kW). At the priority date of the present application the applicant is not aware of anyone having been successful in manufacturing a fiber which would let even a 200-kW pulse go through, with a 15-ps duration, with the pulse remaining optimal.

In any case, if we want limitless possibilities in plasma production from any available material, the pulse power level should be fairly freely selectable, e.g. between 200 kW and 80 MW.

However, the problems associated with present-day fiber lasers are not solely limited to the fibers, but pertain also to the coupling together of separate diode pumps through optical couplers in order to achieve a desired total power so that the resulting beam could be conducted through a single fiber to the work spot.

The applicable optical couplers should be able to withstand as much power as the optical fiber which carries high-power pulses to the work spot. In addition it should be taken into account that the pulse shape should remain optimal throughout all propagation stages of the laser beam. Optical couplers that can withstand even the currently applied power values are especially expensive to manufacture, are fairly unreliable and, being parts that wear out, need to be replaced regularly.

Previously known techniques based on the use of a laser beam and ablation are associated with power and quality problems so that e.g. from the ablation standpoint and especially in connection with scanning, the repetition frequency cannot be raised to a level which would enable mass production on an industrial scale with a uniform and good product quality. In addition, scanners according to the prior art are placed outside the vaporizing device (vacuum chamber) so that the laser beam has to travel through the optical window of the vacuum chamber, which always diminishes the power to some extent.

The effective power of prior-art ablation apparatuses known to the applicant at the priority date is on the order of 10 W. Then the repetition frequency, for instance, may also be limited to just 4 MHz chopped with laser. If one attempts to increase the pulse frequency further, the scanners according to the prior art may cause a significant part of the pulses of the laser beam hitting uncontrollably the wall structures of the laser apparatus, and also into the already-ablated material in the form of plasma, having the net effect that the quality of the surface to be produced will suffer as will also the production rate. Furthermore, the radiation flux hitting the target will not remain uniform, which may affect the structure of the plasma, which thus may, upon hitting the surface to be coated, produce a coating of uneven quality.

Thus also in machining applications in which the target is a piece and/or part to be machined, the surface of which is to be treated, it easily happens that both the cutting efficiency and the quality of the cut will suffer. In addition, there is a significant risk of fragments and spatters landing on surfaces around the cutting point as well as on a surface to be coated. Furthermore, when operating in accordance with the prior art, the repeated surface treatments are slow and the quality of the end result is not necessarily uniform.

With scanners according to the prior art, of which the applicant is aware at the priority date of the present application, the scanning rate remains below 3 m/s, and even then, the scanning rate is not really constant but varies during the scan. This is mainly because scanners according to the prior art are based on turning mirrors which stop when the scanning distance has been traveled, and then turn in the opposite direction, repeating the scan. Back-and-forth-moving mirrors are known as such, but they have the same problems associated with the uniformity of motion. Ablation technology implemented with planar mirrors is described in patent publications US 6,372,103 and US 6,063,455. Since the scanning rate is not constant, due to the accelerating, decelerating and stopping movement, also the yield of plasma generated through vaporization at the work spot is different at different points of the target, especially at the extremities of the scanning area, because the yield and also the quality of the plasma completely depend on the scanning rate. In a certain sense it could be considered a main rule that the higher the energy level and number of pulses per time, the more severe the disadvantage, when using apparatuses according to the prior art. In successful ablation, matter is vaporized into atomic particles. But when there is some disturbance, fragments may be freed/detached from the target material or fragments may be attached to it, which may be several micrometers in size, which naturally affects the quality of the surface to be produced by means of ablation.

Since the speeds of the scanners known today are low, increasing the pulse frequency would result in the energy level of the laser beam pulses arriving at the mirror structures to be so high that present-day mirror structures would melt/burn if the laser beam were not expanded prior to its arrival at the mirror of the scanner. Therefore, additional separate collecting lens arrangements are needed between the scanner and ablation target.

The main operationally limiting characteristic of current scanners is that they are light. This also means that they have a small mass and, thus, small energy absorption capacity to absorb the energy of the laser beam. This factor causes an increased risk of melting/burning in applications according to present-day technology.

One problem in the prior art is the scanning width. These solutions use line scanning with mirror film scanners which theoretically could achieve a scan line width of about 70 mm, but in practice the scanning width may problematically remain even below 30 mm, whereby lattice-like areas may remain in an uneven manner both qualitatively and regionally. A scanning width so small supports the fact that the current laser apparatuses in surface treatment applications for large and wide objects are unfeasible industrially or are technically impossible to implement.

If there occurs a situation according to the prior art, where the laser beam is out of focus, the resulting plasma may be of quite a poor quality. The freed plasma may also contain fragments coming loose from the target. At the same time material meant to come off the target may be damaged to such an extent that it cannot be used any more. The situation is typical of solutions according to the prior art which use a far too thick target as a source of material. In order to keep the focus optimal, the target must be moved in the direction of incidence of the laser beam to an extent which corresponds to the consumption of the target. Unsolved remains then the problem that even if the target were brought back into focus, the structure and composition of the target surface may have changed in proportion to the amount of material vaporized off it. According to the prior art, the structure of the surface of a thick target changes as it is consumed. For instance, if the target is a compound or an alloy, the problem is easily noticed.

In arrangements according to the prior art, a change in the focus of the laser beam in the middle of ablation, relative to the vaporized matter, will immediately affect the quality of the plasma, because the energy density of the pulses arriving on the surface will usually decrease, whereby vaporization / generation of plasma is no longer complete. This results in low-energy plasma and an unnecessarily large amount of fragments/particles as well as changes in the surface morphology, and possible changes in the adhesion and/or thickness of the coating.

Attempts have been made to alleviate the problems by focus adjustment. When in an equipment according to the prior art the repetition frequency of the laser pulses is low, say below 200 kHz, and the scanning speed a measly 3 m/s or less, the speed of change of the intensity of plasma is low, whereas the equipment has time to react to the change of the intensity of plasma by adjusting the focus. A so-called real-time plasma intensity measuring system can be used when a) the quality of the surface and its uniformity are of no importance, b) at a low scanning speed.

Therefore, according to the information available to the applicant at the priority date of the present application, it is not possible to produce high-quality plasma using technology according to the prior art. Therefore, many coatings cannot be manufactured using prior-art techniques.

Systems according to the prior art require complicated systems which have to be used in them. In known methods the material target is usually in the form of a thick bar or sheet. This requires the use of a zooming focusing lens or the target must be moved towards the laser beam as the target is consumed. Even a practical implementation of this is already technically extremely expensive and difficult, if at all possible in a manner sufficiently reliable, and there are unnecessarily large variations in the quality, whereby precise control is almost impossible, the manufacture of a thick preform is expensive and so on.

In addition, special structures almost invariably have to be made either as individual pieces and/or in small series so that varying quality but also high manufacturing costs prove problematic and limit or completely exclude the applicability of the special structures in mass products.

An objective of the invention, therefore, is to solve the problems of the prior art as regards heating, or at least to alleviate them. The objective of the invention is achieved by an element according to the invention.

JP-A-2000 299 028 discloses a method of manufacturing a transparent conductive film on a substrate by laser ablation.

An element according to the invention is characterized in that which is presented in the characterizing part of the independent claim directed thereto. The use of an element according to the invention is characterized in that which is presented in the characterizing part of the independent claim directed to the use. A window structure according to the invention is characterized in that which is presented in the characterizing part of the independent claim directed thereto.

An object of the invention is to introduce a surface treatment apparatus by means of which it is possible to solve the problems associated with the prior art or at least alleviate them. Another object of the invention is to introduce a method, apparatus and/or arrangement for coating an object more efficiently and with a better-quality surface than is known according to the prior art at the priority date of the present application. Yet another object of the invention is to introduce a three-dimensional printing unit implementable with the help of a technique in which an object is repeatedly coated using a surface treatment apparatus more efficiently and with a better surface than can be done in the prior art at the priority date of the present application. The objects of the invention are associated with the following aims as follows:

A first aim of the invention is to produce at least a new method and/or related means for solving the problem of how to produce high-quality, fine plasma practically from any target in such a manner that the target material will not form any fragments in the plasma, i.e. the plasma is pure and said fragments, if any, appear only sparsely and have a size smaller than the ablation depth at which the plasma is generated by ablating the target.

A second aim of the invention is to produce at least a new method and/or related means for solving the problem of how to produce, by freeing high-quality plasma, a fine and even cut to be used in a cold machining method which removes material from a target down to an ablation depth in such a manner that the target machined will not form any fragments in the plasma, i.e. the plasma is pure and said fragments, if any, appear only sparsely and have a size smaller than the ablation depth at which the plasma is generated by ablating the target.

A third aim of the invention is to produce at least a new method and/or related means for solving the problem of how to coat a surface of an area serving as a substrate using high-quality plasma which includes no particulate fragments at all, i.e. the plasma is pure and said fragments, if any, appear only sparsely and have a size smaller than the ablation depth at which the plasma is generated by ablating the target, i.e. to coat the surface of the substrate using pure plasma which can be produced from practically any material.

A fourth aim of the invention is to produce at least a new method and/or related means for solving the problem of how to achieve, using high-quality plasma, a coating with good adhesion properties for adherence to a substrate in such a manner that wasting of kinetic energy on particulate fragments is diminished by restricting the occurrence of fragments or limiting their size so as to be smaller than the ablation depth. At the same time fragments, due to their absence, will not generate cool surfaces which could affect the homogeneity of the plasma jet through nucleation and condensation. Additionally, according to the fourth aim, the energy of the radiation is efficiently converted into plasma energy when the impact area of the heating is minimized when advantageously using short radiation pulses, i.e. picosecond-range pulses or shorter in duration, and a certain pulse interval between two consecutive pulses.

A fifth aim of the invention is to produce at least a new method and/or related means for solving the problem of how to achieve a broad scanning width with simultaneous high quality of plasma and a large coating breadth even for big objects on an industrial scale.

A sixth aim of the invention is to produce at least a new method and/or related means for solving the problem of how to achieve a high repetition frequency to be used in applications of an industrial scale in line with the aims mentioned above.

A seventh aim of the invention is to produce at least a new method and/or related means for solving the problem of how to produce high-quality plasma for coating surfaces in order to manufacture products in line with the aims one through six, yet saving target material to be re-used at coating stages, producing coatings/thin films of the same quality where needed.

An additional aim of the invention is to use methods and means in line with said first, second, third and/or fifth aim for solving the problem of how to cold-machine and/or coat surfaces in line with each applicable type of such products.

The objects of the invention are achieved by producing high-quality plasma by a surface treatment apparatus based on the use of radiation, which apparatus, according to an embodiment of the invention, includes a turbine scanner in its radiation transmission line.

When using the surface treatment apparatus according to an embodiment of the invention, the removal of material from the surface treated and/or the yield for coating can be raised to a level required of high-quality coating and, what is more, with sufficient production rate and without unnecessary restrictions on the radiation power.

Other embodiments of the invention are presented as examples in the dependent claims. Embodiments of the invention can be combined where applicable.

Embodiments of the invention can be utilized in the manufacture of products and/or coatings, whereby the materials for the product can be chosen rather freely. For example, semiconductor diamond can be produced, but in a manner suitable for mass production, large numbers, cost-efficiently, repeatably and with a good quality.

In a group of embodiments of the invention the surface treatment is based on laser ablation, whereby it is possible to use almost any laser source as a source of radiation to be transmitted via a radiation transmission line having a turbine scanner. Applicable laser sources then include such as CW lasers, semiconductor lasers and pulsed laser systems where the pulses are in the picosecond, femtosecond or attosecond range, the last three of which represent lasers applicable to cold machining methods. The invention, however, does not limit the radiation source itself.

Based on the teachings of the invention it is obvious to a person skilled in the art that an object which at a given stage of surface treatment is called a target may at another stage of surface treatment be a substrate and vice versa, depending on whether material is being ablated off of it (target) or whether material is being brought onto it (substrate). Thus it is at least theoretically possible that one and the same object could serve both as a substrate and as a target depending on the stage of machining/deposition.

Other embodiments of the invention are presented in dependent claims.

The invention will now be described in more detail referring, by way of example, to the accompanying drawings wherein
- Figure 1: illustrates an element according to an embodiment of the invention,
- Figure 2: illustrates film structure variations of an element according to an em- bodiment of the invention,
- Figure 3: illustrates an element according to an embodiment of the invention in a curved surface geometry,
- Figure 4: illustrates a group of elements according to an embodiment of the inven- tion,
- Figure 5: illustrates film composition of film structures of an element according to an embodiment of the invention,
- Figure 6: illustrates the use of an element according to an embodiment of the in- vention in connection with a vehicle,
- Figure 7: illustrates the use of an element according to an embodiment of the in- vention in connection with an aircraft,
- Figure 8: illustrates the use of an element according to an embodiment of the in- vention as a part of an airplane,
- Figure 9: illustrates the use of an element according to an embodiment of the in- vention as a part of a watercraft,
- Figure 10: illustrates the use of an element according to an embodiment of the in- vention for advertising and artistic purpose,
- Figure 11: illustrates a manufacturing method for an element according to an em- bodiment of the invention,

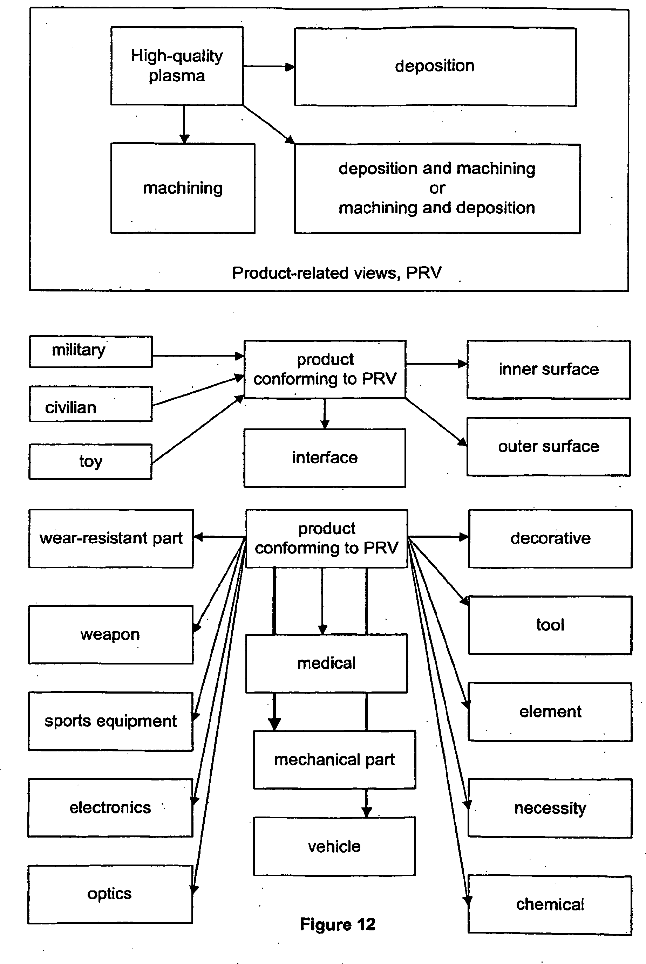

- Figure 12: illustrates examples of products according to embodiments of the inven- tion, and
- Figure 13: illustrates disadvantages of the prior art.

An element here means a functional unit such as a heater and/or cooler, which are called elements, but in an embodiment of the invention an element also includes a substrate on which the functional part proper is formed. Thus, for example, a windscreen of an automobile or some other glass onto which a heating element (and/or cooling element) has been post-installed by means of ablation, only contains, in an embodiment of the invention, a heating element (and/or cooling element), but that same glass which already at the factory has been manufactured so as to comprise said elements can be considered an element, with the glass included as a substrate in the element. A glass in this case refers to a shield or cover of a transparent material, without taking a stand on the composition and/or structure of the glass as such.

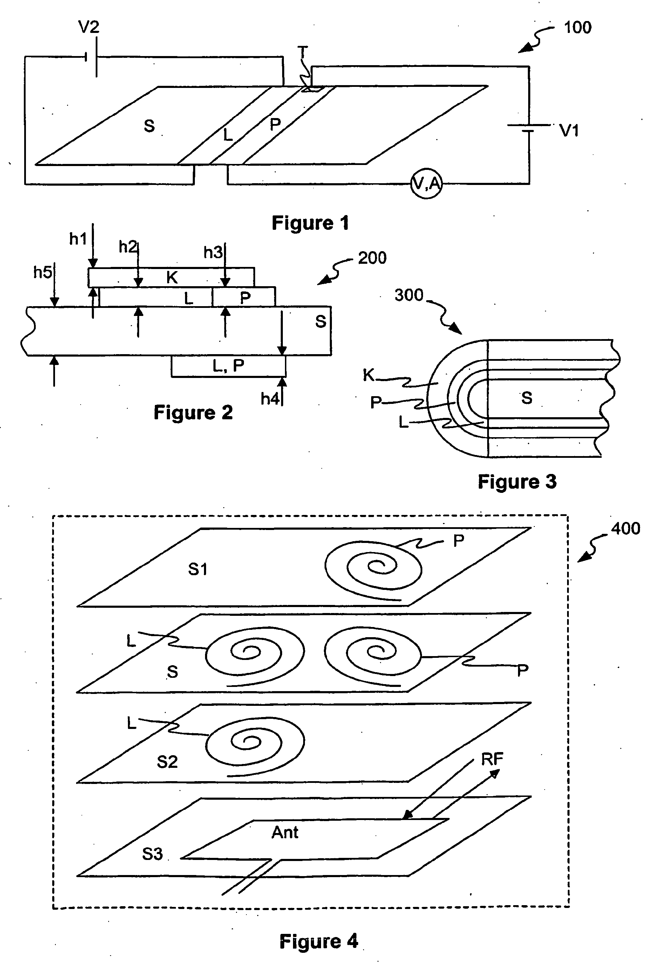

Fig. 1 shows an element 100 according to an embodiment of the invention comprising a substrate S on a surface of which a heatable filmy structure L is drawn, the thickness h2 of which is illustrated in Fig. 2. In Fig. 1 the heating element L is shown to be connected to a voltage supply V2 in order to supply electric power through a length of the element L so that the element operates as a heating resistor, the electric current heating it up. Even though the element L is depicted to be strip-like, the example presented is not intended to limit the shape of the element. Let it also be noted that the voltage supply may in an embodiment of the invention be also an AC supply, despite what is shown in the drawing.

Fig. 1 shows an element 100 according to an embodiment of the invention comprising a substrate S on a surface of which a coolable filmy structure P is drawn, the thickness h3 of which is illustrated in Fig. 2. In Fig. 1 the cooling element P is shown to be connected to a voltage supply V1 in order to supply electric power (V,A) through a length of the element P so that the element operates as a cooling element, the electric current cooling it down. Even though the element P is depicted to be strip-like, the example presented is not intended to limit the shape of the element. Let it also be noted that the voltage supply may in an embodiment of the invention be also an AC supply, despite what is shown in the drawing.

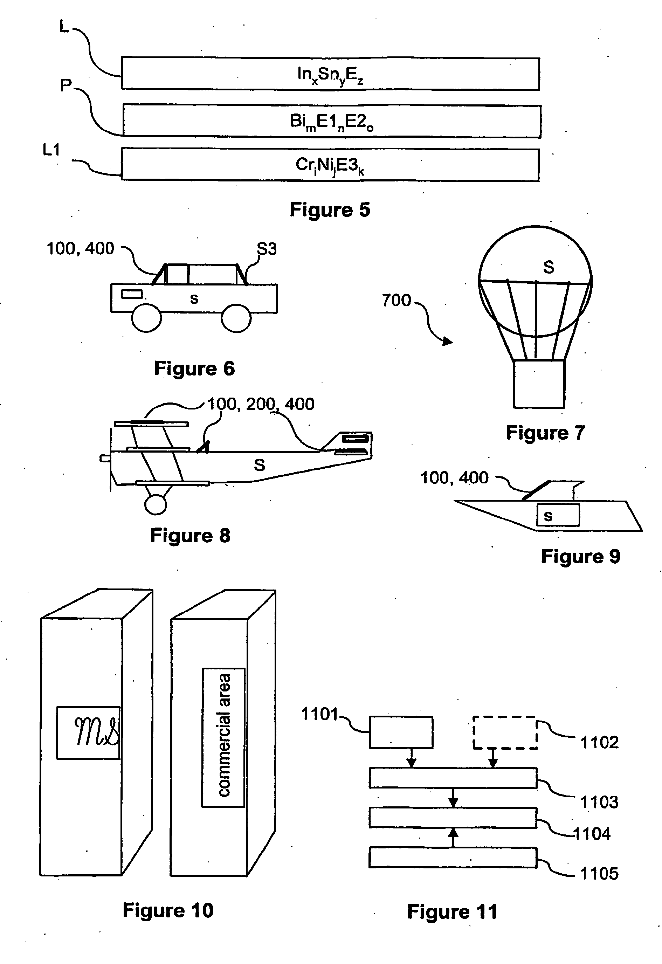

Fit. 1 also illustrates an embodiment of the invention where a switching and/or regulating component T, such as a thyristor, is integrated in the element P in order to regulate the electric power supplied, by regulating either the power, voltage and/or, in the case of alternating current, also the frequency and/or ignition angle. The regulating component T may receive its control from an external circuit such as, in the example case depicted in Fig. 6, a car computer or a weather sensor. Even though in Fig. 1 the regulating component T is shown in connection with the element P, it is obvious to a person skilled in the art, on the basis of what is presented here, that the regulating component may also be placed either alternatively or additionally in connection with the element L. Based on Fig. 1, we can discern at least these distinct embodiments of the invention; a first one in which there is a heating element L on a surface of a substrate S; a second one in which there is a cooling element P on a surface of a substrate S; and a third one in which there are at least one P element and at least one L element.

According to an embodiment of the invention the layer thicknesses of the elements L and/or P are selected such that they will not attenuate, to a disadvantageous extent, the passing of light through the substrate, not even at spots where the element is located, even though the element is, according to an embodiment of the invention, fabricated from an opaque material in a macroscopic sense.

Fig. 2 illustrates the film structure of the substrate S of a sheet-like element 200, without however being limited solely to a Euclidian planar object, but the substrate may also be slightly curved in an embodiment of the invention, such as in connection with an airplane wing, or more steeply curved, such as e.g. in connection with a fiber illustrated in Fig. 3. In Fig. 2 the thickness h5 of the substrate S may be different in the different embodiments illustrated here, but in an embodiment in which some other sub-element, L element and/or P element are on the surface of the film, the thickness of the substrate is the thickness of the film or, depending on the case, the thickness of the layer binding together the element and the film, e.g. in connection with laminated structures.

Fig. 2 also shows on one side of the substrate S a film K which in the example of Fig. 2 covers the element L completely and has a thickness h1. In an embodiment of the invention the film K may comprise an insulator, a photocatalytic layer, a wear-resistive surface, diamond surface, or an optically active surface. Let it also be noted that in an embodiment of the invention it is possible to use the L element to produce a film which is substantially transparent on the wavelengths of visible light and ultraviolet light. Then, using indium, tin and/or oxides of these in the film material in an embodiment of the invention it is possible to achieve very thin films which are conductive but transparent. According to an embodiment of the invention it is possible to use the L element to realize e.g. the conductors in a solar cell or some other photo-electric component so that the conductors can be positioned in front of the cell, on its surface, where applicable, so that said element can be used to shield the cell but also save space, without however significantly disturbing the radiation flow incident to the cell. In a photo-electric cell or similar component it is then also possible to have the wiring on the surface. This way, in an individual solar cell according to an embodiment of the invention there is nearest to the light source a wiring realized by an element according to an embodiment of the invention, and only after that, in the direction of propagation of radiation, there is the cell itself. The arrangement brings a special advantage in solutions of construction technology in which the outer surface of a building is to be coated with a solar cell material. The wiring needed to operate the solar cells, to connect them in series and/or in parallel, can be achieved by an element according to an embodiment of the invention. According to an embodiment of the invention the wiring is arranged for an indoor installation or alternatively for an outdoor wiring. According to an embodiment of the invention said surface can be arranged so as to be heated so that it is possible to implement a defrost functionality, for instance, on the wall of a skyscraper or other building, which wall contains glass or some other transparent film arranged so as to let light pass through into the building. An indoor L element can also bring savings in the heating costs.

Various display solutions may also utilize an element according to an embodiment of the invention. For example, transparent wirings can be realized for a display such as a liquid crystal display. Even a special wiring element can be manufactured for the installation of the liquid crystal display, which wiring element is in fact on the display but, being transparent, is not visible. Thus, space can be saved inside the device.

Furthermore, according to an embodiment of the invention, by combining a self-cleaning film to an element according to the invention it is possible to gain advantage in solar cell applications, for instance. According to an advantageous embodiment of the invention, the surface to be coated is produced such that the surface has less than one hole per 1 mm², advantageously less than one hole per cm², and preferably no holes at all in the area coated. A hole means a hole either through the whole coating or substantially through the coating (pinhole). Holes substantially degrade the quality characteristics of the coating as well as shorten its useful life. The invention also pertains to a product produced this way according to the method.

According to another advantageous embodiment of the invention the surface coated is produced such that the first 50% of the surface is produced without particles being produced on the surface which have a diameter greater than 1000 nm, advantageously without the size of the particles exceeding 100 nm, and preferably without the size of the particles exceeding 30 nm. Such particles substantially degrade the quality of the coating and shorten its useful life. Such particles form corrosion channels in the coating. The invention also pertains to a product produced this way according to the method.

According to yet another advantageous embodiment of the invention the object to be coated, i.e. the substrate, is coated by ablating a target with a pulsed cold machining laser in such a manner that the evenness of the surface produced on the object is ±100 nm measured from an area of one square micrometer using an atomic force microscope (AMF). Advantageously the surface roughness is less than 25 nm, and preferably less than 10 nm. The invention also pertains to a product produced this way according to the method.

On a side of the substrate S opposite to that of film K, there is also shown a film designated with letters L, P the thickness of the film being h4. The thickness of the film P is h3, and the thickness of the film L is h2. Thus we can recognize in Fig. 2 at least the embodiments shown in Fig. 1, but also embodiments in which the film K is used as an additional coating for elements formed of the films L and P. There may also be more additional coatings, and the invention does not limit the number of them in any way.

The film designated with letters L, P may be an L-type heating film according to an embodiment of the invention, or a P-type cooling film according to another embodiment of the invention. According to yet another embodiment of the invention the film may be a composite film with separate L and/or P type films arranged in laminated layers, for instance.

Fig. 3 illustrates an embodiment of the invention in which films K, P and/or L, shown in Fig. 2, are used on a surface of a fiber-like or tubular substrate S. The element 300 in Fig. 3 is shown to be cylindrical, but the invention is not limited to the cylindrical shape, but the substrate and, hence, said layers may be in a geometry according to the Figure or elliptical, for example. Thus, if a film structure is manufactured in a geometry according to Fig. 3, it is possible to produce e.g. a structure corresponding to a woven textile which, single- or multi-layered, may be used in filtering. Then, as regards the grain size of the material filtered and the filtering mechanism in more detail, a person skilled in the art can estimate which size of the filter fiber and/or which structure as such is needed to achieve a certain collecting efficiency for a certain-sized matter in the fluid which is being filtered. Using a fiber according to an embodiment of the invention it is then possible to conduct electric current in the filter fiber itself and thus achieve heating in an L-type film, and cooling in a P-type film. Thus, by heating it is possible e.g. to enhance the drying-up of a filtrate but, on the other hand, by cooling, it is possible to prevent the drying-up from taking place too quickly. When the film K comprises e.g. a photocatalytic film, the filter may, at least to some extent, be self-cleaning but, on the other hand, it may also be sterilized by means of a certain heat cycle. According to an embodiment of the invention it is thus possible to achieve e.g. a multi-stranded thread which can be used to weave a filter according to an embodiment of the invention, which filter can be cooled and/or heated.

Referring to Fig. 3, it is also conceivable that a funnel be manufactured such that on a surface thereof there is, according to an embodiment of the invention, an L and/or P type element arranged so as to produce a certain heating effect. Such elements may also be used, according to an embodiment of the invention, on surfaces of a vessel in order to produce a heating effect. The vessel may be, for example, a condenser, a container or funnel, or a transport pipe.

In Fig. 4, letters S1, S, S2, and S3 illustrate various embodiments of the invention by referring to a substrate on which the element according to the embodiment is located. Even though an embodiment of the invention in Fig. 4 can be understood to refer to an element 400 which can be realized, using the embodiments presented, as a laminated structure, the invention does not limit the elements or their numbers.

On a substrate S1 there is shown a P-type element to produce a thermal effect, which here is a cooling effect. The element P is drawn in the shape of a spiral in order to illustrate an advantageous shape to cover the surface and, thus, produce an even thermal effect, but, on the other hand, also to illustrate a structure in which electric power can be transmitted inductively between laminate layers from a first layer to a second layer without a galvanic contact, by means of an induction loop. It is then natural that the electric current transmitted has an amplitude, frequency and/or waveform, which can be shaped more closely according to an embodiment of the invention, e.g. when a laminate layer contains a switching and/or regulating component by means of which it is possible to adjust the ignition angle of the alternating current (a triac). In Fig. 4 the elements P and L are not shown to be closed, neither does Fig. 4 show the switches nor the electrical supplies as such for producing the thermal effect.

In the layer containing the substrate S there are both an L-type and a P-type element arranged so as to produce a thermal effect. The layer S can thus be used to produce both a heating-type and a cooling-type thermal effect. By feeding said elements independently of each other it is possible to produce simultaneous, successive or overlapping thermal effects. Even though in Fig. 4 the elements L and P are drawn as separate loops in different parts of the substrate S, they can be realized as nested loops where the L and P elements travel in parallel.

An example of an embodiment of the invention is shown in layer S2 comprising just an L element or a plurality of L elements.

Layer S3 illustrates an embodiment of the invention in which an L or a P element realizes also an antenna, Ant, in order to transmit and/or receive a radio-frequency signal RF, represented by the arrows shown in the drawing. Of special advantage is an embodiment of the invention which includes a transparent substrate, an antenna Ant, an L element and/or a P element. An element according to such an embodiment of the invention can be used in the windscreen of an automobile or other vehicle, a boat, train, or an aircraft, for example.

Even though in Fig. 4 the antenna is shown to be a part of a laminated structure on a substrate of its own, in an embodiment of the invention the antenna may also reside on one of the other substrates S1, S, and S2.

Fig. 5 illustrates the composition of an L element and P element according to an embodiment of the invention. Fig. 5 also illustrates the composition of an element L1 according to an alternative composition.

In an element according to an embodiment of the invention an electrically conductive filmy structure of a certain thickness is produced on a substrate by ablating at least one filmy material in order to achieve a thermal effect in the filmy structure by means of electric current. An element according to an embodiment of the invention has in its filmy structure a heatable part arranged as an L element. The heatable part may be arranged so as to be heated through electric resistance and/or inductively coupled current. According to an embodiment, an element comprises a first coil and a second coil, between which there is an inductive coupling in order to transfer electric power between the coils. One of the coils may be formed of electrical resistor material known as such at the priority date, but ablated into a film so that no wires are needed between the coils. Thus, such laminated structures can be used to realize e.g. window structures which are required to be absolutely tight, but which can, however, be heated.

According to an embodiment of the invention an element comprises in its filmy structure a coolable part arranged as a P element. The coolable part may advantageously be arranged on a substrate as an integrated Peltier element which as such may be of a known type. According to an embodiment of the invention such a Peltier element is manufactured by ablating materials which are needed to produce the element. An advantage is then gained in the manufacturing in that the films produced from the materials in cold ablation according to the invention can be formed on the element substrate with a uniform quality in order to make a Peltier element, but also in a layer which is thin enough for embodiments of the invention in which the substrate is intended to function as a window or some other transparent or translucent surface. There may also be a plurality of Peltier elements, arranged so as to form a certain kind of P element.

In an embodiment of the invention it is then also possible to realize a vessel or condenser the temperature of which can be regulated through the thermal effect. Then it is possible e.g. to make a funnel according to an embodiment of the invention such that a heatable element is installed by means of ablation on a surface thereof. According to an embodiment of the invention, a Peltier element can be produced by means of ablation on a surface of the same or another funnel, achieving a cooling thermal effect. Temperature can then be used e.g. to control the growth of microbes directly on a surface of the funnel or on a filter on top of the funnel but, on the other hand, also the viscosity of the fluid, thus controlling the filtering. Thus, when according to an embodiment of the invention a vessel comprises a funnel part and/or a container arranged so as to collect and/or store the liquid phase of the condensed fluid produced by the cooling, the flow itself can be controlled at a certain temperature.

According to an embodiment of the invention the element can be used to realize a simple filmy structure or laminated filmy structure, which is essentially transparent. Complete transparency would require loss-free propagation of radiation at said wavelength, and cannot be achieved in practice, but a few per cent loss, such as in a normal window glass at a wavelength of visible light shall be considered transparency, and an opacity greater than e.g. 5% shall be considered substantial transparency, but on condition that the transparency is still on the order of 70%, approximately. Persons skilled in the art are also well aware of the fact that for a window made from a given material the permeability of radiation varies as a function of the wavelength, at wavelengths outside those of visible light. Although the embodiments related to heatable windows and/or transparent films are given as examples of a window, the invention is not, however, limited to transparency at wavelengths sensed by the human eye. An L element according to an embodiment of the invention has a substantial transparency at least in the wavelength range 400-700 nm. An L element according to an embodiment of the invention has a substantial transparency at least in the wavelength range 80-700 nm. An L element according to an embodiment of the invention has a substantial transparency at least at a wavelength which falls into the wavelength range 650-2000 nm.

According to an embodiment of the invention an L element may be used in infrared filtering, e.g. in connection with optical windows and/or components. According to an embodiment of the invention, it is then possible to use a substrate coated completely on one side or where applicable, to realize structures that can filter infrared radiation. For example, in military clothing, in the structural fibers of clothes, an L film can be used to achieve infrared filtering.

In an embodiment of the invention an element comprises in a filmy structure a thin film and/or thick film arranged so as to vary its temperature by means of an electric current traveling through it. Said film may also be arranged so as to have a very small thickness in the nano-scale so that the film in some embodiments may be less than 500 nm thick, for example. According to an embodiment of the invention the thickness of the film is less than 200 nm. According to an embodiment of the invention the thickness of the film is less than 100 nm. According to another embodiment of the invention the thickness of the film is less than 50 nm. According to a third embodiment of the invention the thickness of the film is less than 25 nm. According to a fourth embodiment of the invention the thickness of the film is less than 13 nm. According to a fourth embodiment of the invention the thickness of the film is less than 6 nm. The invention does not limit the number of films even though above a maximum film thickness is associated with a film as an example. Thus, there may be a plurality of films according to an embodiment of the invention, but advantageously however in such a manner that in spite of the thickness of the films a transparency within a certain wavelength range exists. According to an embodiment of the invention one of the films may be separate from the rest of the films. In that case the film in question may be on another side of the substrate than the rest of the films.

The films may be homogeneous in composition, both as regards the structure and the material, but not, however, limiting the invention in this respect. An example according to an embodiment of the invention is a film which in its material composition on a substrate comprises indium, tin and/other materials.

According to a first group of embodiments the film of an L element comprises indium and tin in its composition. Of the proportions of indium and tin let it be said that in one embodiment of the invention less than 100% of the mass of the film comprises indium. According to another embodiment of the invention the film comprises indium and tin such that less than 90% of the mass of the film is indium. According to a third embodiment of the invention the film comprises indium and tin such that less than 80% of the mass of the film is indium. According to yet another embodiment of the invention the film comprises indium and tin such that less than 70% of the mass of the film is indium. According to yet another embodiment of the invention the film comprises indium and tin such that less than 60% of the mass of the film is indium. According to yet another embodiment of the invention the film comprises indium and tin such that less than 50% of the mass of the film is indium. According to yet another embodiment of the invention the film comprises indium and tin such that less than 40% of the mass of the film is indium. According to yet another embodiment of the invention the film comprises indium and tin such that less than 30% of the mass of the film is indium. According to yet another embodiment of the invention the film comprises indium and tin such that less than 20% of the mass of the film is indium. According to yet another embodiment of the invention the film comprises indium and tin such that less than 10% of the mass of the film is indium.

According to another group of embodiments of the invention an L film is comprised of indium and tin in proportions given for indium in connection with the first group of embodiments, but in this other group of embodiments the indium is in the form of oxide in the film structure. According to a variant of an embodiment of the invention also the proportion of oxygen associated with the indium in the mass of the film is counted as indium.

According to a third group of embodiments of the invention an L film is comprised of indium and tin in proportions given for indium in connection with the first group of embodiments, but in the third group of embodiments the tin is in the form of oxide in the film structure. According to a variant of an embodiment of the invention also the proportion of oxygen associated with the tin in the mass of the film is counted as tin.

In a fourth group of embodiments the film and/or the surrounding structure further contains another substance from a group of other substances in order to achieve other properties of the film structure of an element according to an embodiment of the invention in accordance with each more particular embodiment.

According to a fifth group of embodiments a film is comprised of indium and tin in proportions given for indium in connection with the first group of embodiments, but in the fifth group of embodiments the tin is in the form of a halogen compound and/or chalcogen compound in the film structure. According to a variant of an embodiment of the invention also the proportion of another substance in chemical association with the tin in the mass of the film is counted as tin.

According to a sixth group of embodiments a film is comprised of indium and tin in proportions given for indium in connection with the first group of embodiments, but in the sixth group of embodiments the tin is in the form of a halogen compound and/or chalcogen compound in the film structure. According to a variant of an embodiment of the invention also the proportion of another substance in chemical association with the indium in the mass of the film is counted as indium.

According to a seventh group of embodiments an L element also comprises nickel.

According to an embodiment of the invention the film in the element is arranged so as to achieve a thermal effect. According to that variant of embodiment of the invention said element may also comprise an electric switch component integrated on the substrate in order to couple electric power to said electrically conductive filmy structure. According to an embodiment of the invention said electric switch component comprises a FET, transistor, thyristor, diac, triac and/or a circuit comprised of those mentioned, arranged at least partly so as to couple electric power to said electrically conductive filmy structure.

According to an embodiment of the invention the composition of an L element is arranged such that the surface resistivity of the material thereof is less than 0.0005 Ω/m². According to an embodiment of the invention the composition of an L element is arranged such that the surface resistivity of the material thereof is less than 0.005 Ω/m². According to an embodiment of the invention the composition of an L element is arranged such that the surface resistivity of the material thereof is less than 0.05 Ω/m². According to an embodiment of the invention the composition of an L element is arranged such that the surface resistivity of the material thereof is less than 0.5 Ω/m². According to an embodiment of the invention the composition of an L element is arranged such that the surface resistivity of the material thereof is less than 5 Ω/m². According to an embodiment of the invention the composition of an L element is arranged such that the surface resistivity of the material thereof is less than 50 Ω/m². According to an embodiment of the invention the composition of an L element is arranged such that the surface resistivity of the material thereof is less than 500 Ω/m². According to an embodiment of the invention the composition of an L element is arranged such that the surface resistivity of the material thereof is less than 5 kΩ/m². According to an embodiment of the invention the composition of an L element is arranged such that the surface resistivity of the material thereof is more than 5 kΩ/m². According to an embodiment of the invention said resistivity values are the resistivities of the indium-tin film of an L element according to an embodiment of the invention, whereby also other substances may be present in the films. According to an embodiment of the invention at least some of the indium is replaced by nickel.

According to an embodiment of the invention the composition of an element according to an embodiment of the invention is adapted on the basis of the coefficient of thermal expansion of the substrate. According to an embodiment of the invention an element according to an embodiment of the invention contains a material which is ablated into the film structure of the element in connection with its other materials in order to pre-set the resistivity at a certain value. According to an embodiment of the invention an element according to an embodiment of the invention contains a material which is ablated into the film structure of the element in connection with its other materials in order to pre-set the coefficient of thermal expansion at a certain value for the substrate. According to an embodiment of the invention said material is an additive of an indium-tin film, whereby other materials, too, may be present in the film.

An element according to an embodiment of the invention is arranged such that it has an antenna structure and/or a means for using an electrically conductive filmy structure as an antenna and/or part thereof. According to an embodiment of the invention the antenna may be one of the following: transmitter antenna, receiver antenna, or a combination of the two. More particularly the antenna may be designed in accordance with the special characteristics of its embodiment so as to function as a GPS antenna, mobile station antenna, radio antenna, TV antenna, an antenna for the transmission/reception of a digital signal and/or an analog signal. Let it also be noted that an inductive loop or a similar coil may function as some kind of a helix antenna at the same time as it can function as an element for producing a thermal effect.

According to an embodiment of the invention an element may comprise in addition to a first film structure also a second film structure in order to achieve a first thermal effect and a second thermal effect. This is illustrated by an example depicted in Fig. 4. These thermal effects may be different, occur at different times, and/or be directed to different sides of the substrate (Fig. 2), not, however, being limited to these.

For example, referring to Fig. 4, said first film structure in an element is arranged so as to be an L element for increasing the temperature, and said second film structure is arranged so as to be a P element for decreasing the temperature. According to an embodiment of the invention an element may further include an antenna structure as a partial element in accordance with an embodiment of the invention.

Especially if an element contains a plurality of film structures, it can be manufactured according to an embodiment of the invention in such a manner that it has a film structure integrated on a surface of a part of a substrate, whereby said element is one of a group of similarly formed elements, e.g. layered in a laminate form according to Fig. 4 but not, however, being limited solely thereto. Lamination can be used to prevent the electrically conductive layers/parts from directly touching each other. If, for example, a layer includes tin and/or indium e.g. in a heatable element (substrates S and S2), but there is a Peltier element formed in another layer (substrates S and S1), a direct contact between the layers can then be avoided if necessary. The heatable element can be made resistive (L element in Fig. 1), i.e. a thermal resistor complying with Ohm's law, but in another embodiment of the invention it may be designed so as to function inductively (Fig. 4 depicts both inductive and ohmic) but also according to the eddy current principle.

According to an embodiment of the invention the substrate is a planar substrate. According to an embodiment of the invention the substrate may also be a cylinder, even a thread or a fiber. According to an embodiment of the invention the substrate of the element is one of the following: plastic, paper, textile, fabric, glass, ceramic, stone, metal, pigment or a combination of any of the above. According to an embodiment of the invention the element and the substrate constitute a film that can be bent. According to an embodiment of the invention the film, which can be bent, is arranged so as to be adhesively attached to its substrate.

Then, according to an embodiment of the invention, the thermal effect can be achieved through an element arranged on the surface of such a fiber, whereby the fiber can be used as a part of a web-like structure, for instance. According to an embodiment of the invention, one such web-like structure is arranged for the purpose of filtration so as to produce a thermal effect in connection with the filtering, for pre- and/or post-optimization of the filtering from the point of view of the properties of the material to be filtered. It is then advantageous if e.g. either the outermost or the next-to-outermost surface on the fiber is electrically insulated. In some embodiments of the invention the outermost or next-to-outermost surface of the fiber of said kind may comprise a photocatalyst for breaking down organic matter. Thus, for example, bacterial growth can be kept down by cooling the filter and/or the funnel holding the filter so that a photocatalyst enables the breaking down of bacterial matter by means of light. The filter may also be at a high temperature to kill microbes. The filter and/or its holder may also be cooled and heated cyclically. The cycles may be equal or unequal in length, the cooling cycles with each other or the heating and cooling cycles alternating. Heating and/or cooling may also be utilized to keep the temperature of the element at a certain value.

One application for an element according to an embodiment of the invention is e.g. to be a part of a radar antenna in a radar of a craft designed to travel on ground, at sea and/or in the air. According to an embodiment of the invention also a fixed radar can utilize applicable embodiments of the invention.

Above it was described the use of a heating element in connection with a filter application, but in a similar manner a thermal effect can be achieved e.g. for a part of a vehicle, where applicable. For example, a thermal effect may be directed onto a surface of an airplane, flying boat, ship or some other watercraft, whereby the surface may be a part of a stabilizer, rudder, wing and/or hull. The vehicle may then be e.g. one of the following: boat, ship, submarine, car, truck, bus, railway carriage, engine, trolley bus, tram, subway carriage, airship, balloon, helicopter, airplane, parachute, other air vehicle. A vehicle also refers, where applicable, to vehicles designed for military transport and/or battle duties, such as personnel transport vehicles and battle tanks.

According to an embodiment of the invention a military vehicle can be camouflaged in winter conditions using atmospheric water vapor which is nucleated and/or condensed and, hence, crystallized. Using an efficient enough P element on the surfaces of the vehicle which are to be camouflaged, the beginning of nucleation and condensation can be made quicker in sub-zero temperatures, but also in higher temperatures in a manner depending on the cooling power of the P element. Conversely, in situations where ice, frost or moisture is to be removed from a surface of a military vehicle, it can be achieved using an appropriately designed L element.

According to an embodiment of the invention said military vehicle is a so-called dummy which is towed, drawn and/or radio-controlled at a distance from a more important target - such as an expensive stealth-coated armored vehicle - with the purpose of drawing enemy fire to the dummy instead of the real target. Thus, using a P element, for example, in the surface structure of the dummy, an ice/water coating can be produced on the dummy, which can be visible in certain radar applications so that it is assumable that the enemy will fire at the visible target, thereby increasing the survival chances of the military vehicle proper under fire. According to an embodiment of the invention, a dummy is arranged, by means of an L element, so as to be especially well visible in the infrared range.

Figs. 6 to 9 illustrate examples of use of an element according to an embodiment of the invention, using various vehicles as examples. In Fig. 6 the element is used in connection with a vehicle. Although the thick line is intended to emphasize the windscreen and/or rear window, as well as the side window, of the vehicle, also other parts of the vehicle may serve as substrates (S) for L and/or P type elements, but an element comprising antenna functions is best suited for non-metallic parts, especially windows. Furthermore, an element according to an embodiment of the invention can also be used e.g. in skylight windows both in automobiles and in buildings, but also in greenhouses. Globes of lamps can be equipped with elements according to an embodiment of the invention for the purpose of heating/cooling them. Thus, for example, the headlights of a vehicle can be kept free of ice/slush/snow in winter conditions by heating the surfaces of the lighting equipment by means of an L element, for instance.

In Fig. 7 the substrate S is a part of a hot-air balloon to illustrate the use of an element according to an embodiment of the invention in order to achieve a thermal effect directed to an aircraft 700. It is true that by producing enough electricity it is possible in an aircraft, in a period of time long enough, use an element on a substrate S to control the weight of the air vehicle e.g. by means of water condensed on the element. However, in an embodiment of the invention for producing sufficient condensation for weight control purposes for a large air vehicle solely by means of condensation, using Peltier elements known at the priority date of the present invention, the efficiency of such elements may not be sufficient for achieving a significant weight increase exclusively by cooling. However, in an embodiment of the invention there may be a plurality of P elements which are arranged to be selectable, so that by choosing certain ones from a large number of P elements the temperature in each can be dropped sufficiently to start nucleation, whereby, using elements small enough, nucleation and, hence, formation of ice can be controlled by controlling the elements in operation. Placement of P and/or L elements can also contribute to the stability control of an aircraft.

Let it be noted, however, that optically visible layers can be produced by means of p elements by combining condensation and lighting, e.g. to achieve an advertisement, on the outer and/or inner surface of a hot-air balloon or some other aircraft, for instance.

Fig. 8 illustrates an airplane, its wing surface, surface of the rudder and/or windscreen, where it is possible to use e.g. an L type element to achieve heating and, thus, reduce ice formation. The substrate S may also be the fuselage of the plane, for example. Even though Fig. 9 shows a triplane, it is obvious to a person skilled in the art that an element according to an embodiment of the invention can also be used in modem passenger, fighter and/or training planes, but also in helicopters. It is further noted that an element according to an embodiment of the invention can be used in the manufacture of a spaceship, as a part thereof.

Fig. 9 illustrates the use of an element in connection with a watercraft. Even though the thicker line in the drawing emphasizes the use of the element in the windshield of a boat, it is obvious to a person skilled in the art that other surfaces, too, may serve as locations for the element. A boat is just an example of a watercraft, which also includes various submarines and/or diving bells, amphibious vehicles, ships, catamarans, various surfaces in sailboats, and also flying boats. Furthermore, it is possible to reduce fogginess in a diver's mask using the element in the transparent part of the mask as long as enough electrical power is provided in order to achieve a thermal effect.

An element may also be used on a surface of a building or such, illustrated in Fig. 10. An element may also be used to create an advertising surface, referring to the text "commercial area" on the twin towers, whereas the letters "ms" refer to a work of art for the technical realization of which the element or group of elements can be used. Then, by means of the thermal effect, e.g. in summer and/or winter conditions, it is possible to achieve, through a change in the liquid phase, changing surfaces which can be lighted in order to create artistic effects by means of said technology. Indeed, one of the uses of the element is on advertising surfaces or surfaces of certain objects. As an example, consider a duplicate of the statue "David", treated in whole or in applicable parts with a film structure according to an embodiment of the invention so that at least part of the statue is arranged as an element by means of which a thermal effect is achieved. When the thermal effect is, say, cooling, condensation is achieved for the cooled part of the statue in conditions of saturated steam. Then, by directing light onto the condensed droplets, lighting effects are achieved, whereby this inherently technical solution can have an effect on the appearance of a work of art. When the thermal effect is heating, a statue placed outdoors, for example, can be heated, in winter, removing any frost possibly covering it. Then the surface onto which the thermal effect is directed may also be more specifically arranged on the basis of the film structure of the element in such a manner that said surface is adapted so as to produce patterns through refracted/reflected light, with the help of the gas sublimated from the fluid which is condensed as a consequence of the thermal effect and/or at least one optical element formed of particles therein. The surface may be one of a group of surfaces which are each separately adapted so as to take into consideration the properties of the condensing fluid.

One use of the invention is such that a P element is used to produce a structure on an outer surface of which it is to be condensed a component, e.g. water, of the gas phase which envelopes said surface. Then in a suitable closed space the water will be condensed on the surface cooled by the P element so that elsewhere, i.e. other than in the immediate vicinity of the P element, the proportion of water vapor in the gas phase is reduced, which improves the operating reliability of an electric appliance, for example.

The surface with which the surface according to an embodiment of the invention is arranged by means of a film structure, may also comprise two separate surfaces. The surface may also be a window surface and/or decorative surface for which a thermal effect can be achieved when there is an element according to an embodiment of the invention on the surface. According to a first embodiment of the invention the element is integrated as a fixed part of the surface through ablation already in the manufacturing stage. According to a second embodiment of the invention the element is later integrated in the surface in a fixed manner, but only after the manufacture of the surface, by means of ablation. According to a third embodiment of the invention the element is on a film which can be glued or otherwise adhered to a window of a building or an automobile, just to name a couple of examples.

According to an embodiment of the invention, an element according to an embodiment of the invention can be fabricated on a surface of a substrate by ablation. Then, according to Fig. 11, the method includes a step of ablating a first film material 1101 and/or a second film material 1102 in order to achieve an electrically conductive filmy structure. The method advantageously includes a step in which at least one film material is selected to be ablated so that a certain thermal effect can be produced on the finished element. Fig. 11 does not show the selection step as such, but it is illustrated using a broken line in connection with step 1102. In the method, a jet of ablated film material is conducted 1103 onto a substrate onto which the material adheres/is attached 1104 formed into a film in a certain manner depending on the intended use of the element. In the method it is also possible to heat 1105 the substrate and/or the material to be ablated in order to achieve a better end result.

According to an embodiment of the invention, an element manufacturing equipment includes a means of ablation for ablating a film material from an ablation target, a means for directing 1103 a jet of ablated film material onto a substrate to produce a film structure, a heating means for pre-heating 1105 the substrate and/or ablation target to improve ablation and/or adhesion. In a manufacturing equipment according to an embodiment of the invention said ablation means comprises a laser source. According to an embodiment of the invention said laser source comprises a picosecond laser, femtosecond laser and/or an attosecond laser. Thus, different lasers can also be used in pre-heating the material to be ablated, in heating the substrate to be coated. It is also possible to use different lasers for different film materials. In that case, a first laser is used for a first film material, which has a first repetition frequency, a first radiation wavelength, a first pulse length and/or a first intensity, arranged so as to ablate a first film material. A second laser is used for a second film material, which has a second repetition frequency, a second radiation wavelength, a second pulse length and/or a second intensity, arranged so as to ablate a second film material.

Advantageously a manufacturing equipment according to an embodiment of the invention comprises in connection with said ablation means a radiation transmission line for laser radiation. To achieve a sufficient repetition frequency and/or to retain the composition and/or structure of the radiation transmission line material, it includes a turbine scanner for laser radiation. Thus it is possible to arrange the repetition frequency of the ablation means for a manufacturing equipment according to an embodiment of the invention to be less than 5 MHz but over 1 MHz. According to another embodiment of the invention the repetition frequency is more than 5 MHz but less than 20 MHz. According to yet another embodiment of the invention the repetition frequency is more than 15 MHz but advantageously less than 30 MHz. According to an embodiment of the invention the repetition frequency is more than 25 MHz but less than 60 MHz. According to yet another embodiment of the invention the repetition frequency is more than 40 MHz but less than 100 MHz. The upper limit for the repetition frequency is actually determined by the mechanical strength of the turbine scanner parts changing the direction of propagation of radiation, considering the effects of the rotating speed, so that by using a suitably strong material it is possible to achieve higher repetition frequencies without the turbine scanner breaking down because of the speed of revolution and/or bearing tolerances.

The manufacture of the film structures of the element itself is arranged to take place within a protective gas atmosphere and/or vacuum in order to achieve sufficient purity, to which end the manufacturing equipment according to an embodiment of the invention comprises a vacuum means and/or protective gas means adapted for the coating of an element. According to an embodiment of the invention the film of the element can be manufactured directly from source materials through ablation. Then it is also possible to use a reactive protective gas to achieve a certain composition of a suitable film material compound. In an embodiment of the invention, the film of an L element is fabricated from pure indium and/or tin in an oxygen atmosphere, in conditions in which the film material is formed on the substrate when ablated indium and oxygen react with each other and/or ablated tin and oxygen react with each other.

It is quite likely that the elementary charge in a jet of matter produced by ablation is brought into an accelerating/decelerating motion and at some point of ablation, e.g. when hitting the surface of the substrate, may generate X-rays as a consequence of sudden deceleration. A manufacturing equipment according to an embodiment of the invention includes a radiation shield for deceleration and/or other radiation for absorbing the radiation generated by an electric charge in accelerating motion. A manufacturing equipment according to an embodiment of the invention includes a fume cupboard, desiccator and/or cycling and extraction means for materials present in the exhaust gases, comprised of surplus matter and freed in the manufacture of the element.

An element according to an embodiment of the invention can be used to produce a window structure according to an embodiment of the invention so that a thermal effect can be achieved by the element in said window structure. According to a variant of a first embodiment of the invention the window structure includes a first sub-layer and a second sub-layer so that said first sub-layer is isolated from said second sub-layer, but said first sub-layer comprises an element according to an embodiment of the invention arranged in the form of a first coil, and said second sub-layer comprises an element according to an embodiment of the invention arranged in the form of a second coil for inductively supplying electric power to said first coil. The thermal effect achieved is one of the following: heating, cooling, holding the temperature, alternation of heating and cooling.

### Examples

A method and product according to the invention are described below, without, however limiting the invention to the examples described. Surfaces were produced using X-lase 10-W picosecond laser manufactured by Corelase Oy and X-lase 20-W to 80-W picosecond laser from Corelase. Pulse energy refers to the total energy of one pulse, focused onto a desired area through optical components. A laser jet was focused onto a spot with a diameter of 13.6 to 20 micrometers. In the examples, the fluence (pulse energy/area) was varied typically between 0.3 and 5.6 J/cm2. The wavelength used in the coating processes was 1064 nm. Since coatings were made with different coating distances and powers and without growing films of different thickness for the different tests, the coating times varied from a few minutes to three hours. In the examples reference is made to nominal laser power. One should understand that part of this nominal power is lost partly in various power losses when the pulse optically travels to the surface of the target. Such power losses occur e.g. in lenses and optical fiber.

### Example 1

In this example a glass plate was coated (Pilkington, 3 to 5-mm thick glasses of different types, pure, cladding glass, tinted glass, activ glass) with indium-tin oxide (In₂O₃:SnO₂, 9:1, Sigma Technology, China). In the same runs we also used pieces of silicon, laboratory glass (2 mm thick, 2 cm x 3 cm piece of boron silicate glass), SS (stainless steel), copper, marble plate and plastic backgrounds (PC, Kapton, Mylar). Sizes of the latter samples varied from 1x1 cm2 to 10x10 cm2 with a thickness of 0.1 to 10 mm. The parameters of the laser equipment were as follows:
nominal power 20 W
repetition frequency 1-4 MHz
pulse energy 2-10 µJ
pulse length 20 ps
distance between target and substrate 50 mm or 30 mm
vacuum level (base level before deposition): 10⁻⁵ mbar; during deposition 10⁻³ mbar to 5x10⁻² mbar, oxygen atmosphere

The resulting indium-tin oxide surface was examined with an atomic force microscope (AFM), optical microscope, and ESEM microscope. The thickness of the indium-tin oxide surface varied in the test series between 50 and 500 nm and the evenness of the surface ± 0.3 to 5 nm measured from an area of 1 µm². No microparticles were detected on the surface. The ITO-coated glass was optically fully transparent. Adhesion of the coating was good, and it was initially tested using the tape test and by scratching. No holes were detected on the coating.

### Example 2

In this example an indium-tin-oxide-coated piece of glass was coated with aluminum-titanium oxide in order to produce a hard, so-called scratch-free coating on top of the indium-tin oxide surface. A fluence of 0.5 to 0.8 J/cm2 was used in the aluminum-titanium oxide coating. The parameters of the laser equipment were as follows:
nominal power 20 W
repetition frequency 1 MHz
pulse energy 2-10 µJ
pulse length 20 ps
distance between target and substrate 30 mm
vacuum level: 10⁻⁵ mbar

The resulting aluminum-titanium oxide surface was examined with an atomic force microscope (AFM) and ESEM microscope. The thickness of the resulting surface varied in the test samples between 50 and 400 nm and the evenness of the surface was under ± 10 nm measured from an area of 1 µm². No microparticles were detected on the surface. The final piece of glass with an ITO coating and an aluminum-titanium oxide coating on top of that was optically transparent. Based on scratch tests and pin-on-disk tests, the abrasion resistance of a structure coated with the oxide was significantly better than without the oxide coating. Adhesion of the multi-layer coating was good. Similar coating results were achieved at a vacuum level 10⁻³ atm. When lowering the vacuum level it is advantageous to make the distance between the target and substrate shorter.

### Example 3

In this example a piece of glass coated in the manner depicted in Fig. 1 was further coated with yttrium-stabilized zirconium oxide in order to produce a hard, so-called scratch-free coating on top of the indium-tin oxide surface. A fluence of 0.5 to 1.0 J/cm2 was used in the Y-ZrO2 oxide coating. The parameters of the laser equipment were as follows:
nominal power 20 W
repetition frequency 1 MHz
pulse energy 2-10 µJ
pulse length 20 ps
distance between target and substrate 10 mm
vacuum level: 10⁻⁵ mbar

The resulting zirconium oxide surface was examined with an atomic force microscope (AFM) and ESEM microscope. The thickness of the resulting surface varied between 100 and 300 nm, approximately, and the evenness of the surface ± 2 nm measured from an area of 1 µm². No microparticles were detected on the surface. The final piece of glass with an ITO coating and a zirconium oxide coating on top of that was optically transparent. Based on scratch tests and pin-on-disk tests, the abrasion resistance of a structure coated with the oxide was significantly better than without the oxide coating.

### Example 4

In this example a sheet-form piece of glass and polycarbonate (3 cm x 3 cm, thickness 1.2 mm) was coated with indium-tin oxide in such a manner that an indium-tin alloy was ablated with laser in a reactive oxygen phase. At first, the chamber was pumped into a pressure of about 10⁻⁵ mbar. The pumping was suitably throttled by means of a check valve before letting the reactive gas in. The pressure of the oxygen gas was regulated according to a vacuum gauge typically from 10⁻⁴ to 10⁻¹ mbar by means of a gas supply valve. The laser dose was controlled such that at each gas pressure the ablation threshold was reached and a stable ablation stage was achieved where the target would no more excessively spark and no macro-particles would visibly come off it. The parameters of the laser equipment were as follows:
nominal power 20 W
repetition frequency 1-4 MHz
pulse energy 2-10 µJ
pulse length 20 ps
distance between target and substrate 10-70 mm
Vacuum level: 10⁻⁵ mbar before supplying the reactive gas.

The resulting indium-tin oxide surface was examined with an atomic force microscope (AFM) and ESEM microscope. The thickness of the indium-tin oxide surface was between 50 and 100 nm, approximately, and the evenness of the surface ± 1 nm measured from an area of 1 µm². No microparticles were detected on the surface. Adhesion of the coating was good, and it was initially tested using the tape test and by scratching. Conductivity of the surfaces produced was initially tested using surface measurement with an accurate multimeter (Fluke 189). The surfaces appeared to be conductive, behaving just like ITO surfaces produced by other methods and tested in a similar manner.

### Example 5

In this example a steel object was coated with a titanium oxide coating. The parameters of the laser equipment were as follows, and the surface was produced by ablating titanium in a helium atmosphere containing oxygen. Tests were conducted at different gas pressures with the vacuum total pressure varying between 0.5 and 10⁻² mbar according to a vacuum gauge.
nominal power 20-80 W
repetition frequency 1-20 MHz
pulse energy 2-10 µJ
pulse length 10, 20 ps
distance between target and substrate 1 mm approximately
vacuum level: 5*10⁻¹ to 10⁻² mbar (supply of both oxygen and helium)

The resulting titanium oxide surface was examined with an atomic force microscope (AFM), optical microscope, and ESEM microscope. The thickness of the titanium oxide surface was about 50 nm, and the evenness of the surface ± 3 nm measured from an area of 1 µm². The films appeared to be equivalent to similar films fabricated by us by means of ablation from a TiO₂ source.

### Example 6

A slab of marble (100 mm - 100 mm) was coated by ablating an indium-tin metal target (9:1) in active oxygen, 10⁻⁴ to 10⁻¹ mbar. The pulse frequency used was 4 MHz, pulse length 5 µJ, and pulse length 20 ps. The distance between the target and the substrate was 35 mm. The vacuum level was 10⁻⁵ atm before supplying the active gas. The method resulted in a continuous, transparent and hole-free coating with a thickness of 100 nm approximately. Surface roughness was measured to be less than 3 nm from an area of 1 µm2 (AFM). Electrical resistance was measured to be 2.2 x 10⁻³ Ω/m².

### Example 7

A piece of a sheet of copy paper (80 g/m², 100 mm x 100 mm) was coated by ablating an ITO in oxide form (90 w-% In₂O₃; 10 w-% SnO₂) at a pulse frequency of 3 MHz while the pulse energy was 5 µJ and the pulse length 20 ps. The distance between the target and the substrate was 40 mm. The vacuum level was 10⁻⁶ atm during the coating process. The process produced a continuous, transparent coating. The thickness of the coating was 570 nm.

### Example to demonstrate drawbacks of prior art

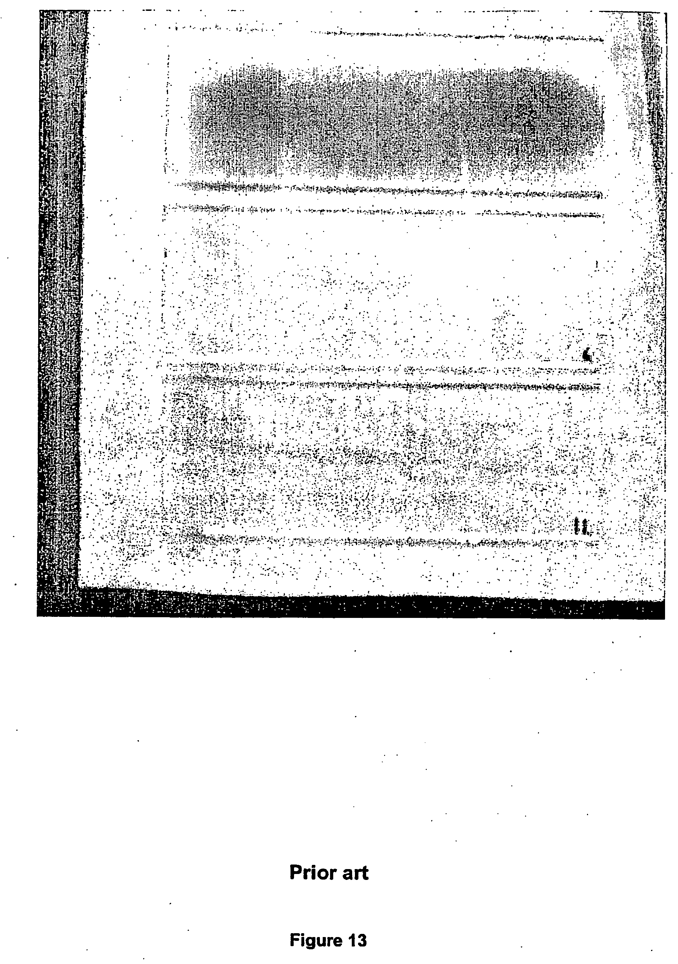

Fig. 13 illustrates an example of a deposition of an ITO coating (Indium-Tin-Oxide) on a piece of polycarbonate sheet (~100 mm x 30 mm) using an optical scanner according to the prior art, namely an oscillating (galvano-scanner) for different ITO thin film thicknesses (30 nm, 60 nm, and 90 nm). Fig. 13 clearly demonstrates the drawbacks associated to oscillating mirror solutions used as optical scanner especially with ultra-short pulse laser deposition (USPLD) but also in laser-assisted coating in general. Since an oscillating mirror changes the direction of its rotating movement at the extremities thereof, and since it has a moment of inertia, the angular velocity of the mirror is not constant in the vicinity of an end point of the movement. Because of the oscillating movement, the mirror constantly has to decelerate and stop before accelerating again, thus resulting in uneven target treatment at the fringes of the scanning area. This, in turn, results in poor quality plasma, which may also include particles especially at the fringes of the scanning area, eventually leading to an uneven coating result like that shown in the Figure. The deposition parameters in this example are chosen so as to demonstrate the uneven distribution with the ablated matter so as to make clear the nature of the scanner. If, however, the same scanner is used and the parameters are appropriately chosen so as to improve the quality of the film, the problems become invisible to the naked eye, but are not, however, eliminated.

Such problems are common in nanosecond lasers generally speaking, but also in present picosecond lasers if they were used in connection with scanners according to the prior art.

### Example on ensemble of embodiments of the invention relating to the embodied element

An element according to an embodiment of the invention comprises an electrically conductive filmy structure of a certain thickness produced on a substrate by ablating, with high-quality plasma, at least one film material in order to achieve a thermal effect in the filmy structure by means of electric current. According to an embodiment, the element comprises a heatable part in the filmy structure. According to an embodiment, in the element, the heatable part is arranged so as to be heated through electrical resistance and/or inductively coupled current. According to an embodiment, the element comprises a coolable part in the filmy structure. According to an embodiment, in said element the coolable part is arranged so as to be a Peltier element integrated on a substrate. According to an embodiment, in said element it comprises a funnel part and/or a container arranged so as to collect and/or store the liquid phase of the condensed fluid produced by the cooling, at a certain temperature. According to an embodiment, said element comprise the filmy structure thar is substantially transparent. According to an embodiment of the invention the element comprises in a filmy structure a thin film and/or thick film arranged so as to vary its temperature by means of an electric current traveling through it.

According to an embodiment of the invention in said element said film thickness is less than 100 nm. According to an embodiment of the invention in said element said film thickness is less than 50 nm. According to an embodiment of the invention in said element said film thickness is less than 25 nm. According to an embodiment of the invention in said element said film thickness is less than 13 nm.

According to an embodiment of the invention said element further comprises integrated on a substrate an electrical switch component for coupling electric power to the electrically conductive filmy structure. According to an embodiment of the invention in said element the electric switch component comprises a FET, transistor, thyristor, diac, triac and/or a circuit comprised of those mentioned, arranged at least partly so as to couple electric power to the electrically conductive filmy structure. According to an embodiment of the invention in said element it has an antenna structure and/or a means for using an electrically conductive filmy structure as an antenna and/or part thereof. According to an embodiment of the invention in said element the antenna is one of the following: transmitter antenna, receiver antenna, or a combination of the two. According to an embodiment of the invention in said element, the antenna comprises one of the following: a GPS antenna, a mobile phone antenna, a radio antenna, a TV antenna, an antenna for transmitting/receiving a digital signal and/or an analog signal. According to an embodiment of the invention that the element comprises a first film structure and a second film structure for achieving a first thermal effect and for achieving a second thermal effect. According to an embodiment of the invention in said element said first film structure is arranged so as to raise the temperature and said second film structure is arranged so as to drop the temperature. According to an embodiment of the invention the element further comprises an antenna structure.

An element according to an embodiment of the invention the element has a laminated structure so that that the element has a filmy structure integrated on the surface of a part of a substrate, whereby the element is one of a group of other similarly formed elements layered as a laminate. According to an embodiment of the invention the element according to an embodiment of the invention contains tin as one constituent in the filmy structure. According to an embodiment of the invention the element according to an embodiment of the invention contains indium as one constituent in the filmy structure. According to an embodiment of the invention the element according to an embodiment contains bismuth as one constituent in the filmy structure. According to an embodiment of the invention an element according to an embodiment of the invention has got a resistance from a filmy material composed of indium and tin. According to an embodiment of the invention, in the element according to an embodiment of the invention the substrate of the element is one of the following: plastic, paper, textile, fabric, glass, ceramic, stone, metal, pigment or a combination of any of the above. According to an embodiment of the invention, the element and the substrate constitute a bendable film.

According to an embodiment of the invention the element is arranged on a surface of a fiber to achieve a web-like structure. According to an embodiment of the invention, the element is is arranged on a surface of a fiber to achieve a thermal effect in a filter structure. According to an embodiment of the invention, in the element, the outermost or next-to-outermost surface of said fiber is electrically insulated. According to an embodiment of the invention, in the element the outermost or next-to-outermost surface of said fiber comprises a photo-catalyst for breaking down organic substances.

### Example on ensemble of embodiments of the invention relating to the use of the embodied element

According to an embodiment of the invention the use of an element according to an embodiment of the invention comprises such a use to achieve a thermal effect on a surface, when the element is an element according to an embodiment. Use of an element according to an embodiment of the invention comprises use for such a thermal effect which means raising a temperature. Use of an element according to an embodiment of the invention comprises use for such a use in which the thermal effect means sustaining a temperature which has been set. Use of an element according to an embodiment of the invention comprises use for such a use in which the thermal effect means decreasing a temperature. Use of an element according to an embodiment of the invention comprises use for such a use in which the surface is a part of a stabilizer, rudder, wing and/or hull. Use of an element according to an embodiment of the invention comprises use for such a use in which the surface is a part of an antenna of a radar. Use of an element according to an embodiment of the invention comprises use for such a use in which the surface is a part of a vehicle. Use of an element according to an embodiment of the invention comprises use for such a use in which the vehicle is one of the following: boat, ship, submarine, car, truck, bus, railway carriage, engine, trolley bus, tram, subway carriage, airship, balloon, helicopter, airplane, parachute, other air vehicle. Use of an element according to an embodiment of the invention comprises use for such a use in which the surface is a surface of a part of a building. Use of an element according to an embodiment of the invention comprises use for such a use in which the surface is an advertising surface.

Use of an element according to an embodiment of the invention comprises use for such a use in which the surface is a surface of a changing work of art. Use of an element according to an embodiment of the invention comprises use for such a use in which the surface is adapted so as to produce patterns through refracted/reflected light with the help of a gas sublimated from the liquid which is condensed as a consequence of the thermal effect and/or by means of at least one optical element formed of particles formed from it. Use of an element according to an embodiment of the invention comprises use for such a use in which the surface is one of a group of surfaces which are each separately arranged the liquid condensed. Use of an element according to an embodiment of the invention comprises use for such a use in which the group comprises at least two different surfaces. Use of an element according to an embodiment of the invention comprises use for such a use in which the surface is a window surface. Use of an element according to an embodiment of the invention comprises use for such a use in which the surface is a decorative surface. Use of an element according to an embodiment of the invention comprises use for such a use in which the method includes a step for ablating, to produce a high-quality plasma, a first film material and/or a second film material to achieve an electrically conductive filmy structure. Use of an element according to an embodiment of the invention comprises use for such a use in which the method includes a step in which at least one film material is selected to be ablated in order to achieve a certain thermal effect for the finished element.

### Example on ensemble of embodiments of the invention relating to manufacturing an embodied element

According to an embodimen of the invention a surface-treatment equipment according to an embodiment of the invention has in its radiation transmission line a turbine scanner for working and/or coating a work-piece using high-quality plasma.

A method for manufacturing an element according to an embodiment of the invention, comprises in the method, in addition to ablating a film material from an ablation target to produce high-quality plasma, directing a jet of the film matter onto the substrate of the element to produce a film structure, and pre-heating the substrate and/or the ablation spot on the ablation target, in order to improve ablation and/or adhesion on the substrate.

An element manufacturing equipment according to an embodiment of the invention includes a means of ablation for ablating a film material from an ablation target to produce high-quality plasma, a means for directing a jet of ablated film matter onto the substrate of the element to produce a film structure, a heating means for pre-heating the substrate and/or ablation target to improve ablation and/or adhesion. An element manufacturing equipment according to an embodiment of the invention is so arragned that said ablation means comprises a laser source for producing high-quality plasma. An element manufacturing equipment according to an embodiment of the invention comprises in said element manufacturing equipment said laser source which comprises a picosecond laser, femtosecond laser and/or attosecond laser for producing high-quality plasma. An element manufacturing equipment according to an embodiment of the invention is so arranged that in said element manufacturing equipment said ablation means comprises a radiation transmission line for laser radiation for producing high-quality plasma. An element manufacturing equipment according to an embodiment of the invention is so arranged that in said element manufacturing equipment said ablation means comprises in a radiation transmission line a turbine scanner for laser radiation for producing high-quality plasma. An element manufacturing equipment according to an embodiment of the invention is so arranged that in said element manufacturing equipment the ablation means is arranged to have a repetition frequency in excess of 30 MHz, advantageously over 60 MHz, but preferably over 100 MHz for producing high-quality plasma. An element manufacturing equipment according to an embodiment of the invention comprises a vacuum means and/or protective gas means for coating an element, arranged so as to produce high-quality plasma. An element manufacturing equipment according to an embodiment of the invention comprises a radiation shield for deceleration radiation for producing high-quality plasma. An element manufacturing equipment according to an embodiment of the invention comprises a fume cupboard, desiccator and/or cycling and storage means for the surplus material present in the exhaust gases freed in the manufacture of an element, for the purpose of producing high-quality plasma.

### Example on ensemble of embodiments of the invention relating to window structure

A window structure according to an embodiment of the invention comprises an element according to an embodiment of the invention for producing a thermal effect. A window structure according to an embodiment of the invention includes a first sub-layer and a second sub-layer so that said first sub-layer is isolated from said second sub-layer, but said first sub-layer comprises an element according to an embodiment of the invention as arranged in the form of a first coil, and said second sub-layer comprises an element according to an embodiment of the invention as arranged in the form of a second coil for inductively supplying electric power to said first coil. A window structure according to an embodiment of the invention is so arranged that the thermal effect for said window structure is one of the following: heating, cooling, holding the temperature, alternation of heating and cooling.

## Claims

1. An element, **characterized in that** the element comprises an electrically conductive filmy structure of a certain thickness, which filmy structure does not contain particles larger than 30 nanometres in diameter and has been produced on a substrate with high-quality plasma containing material cold ablated from an ablation target, in order to achieve a heating or cooling effect in the filmy structure by means of electric current coupled to the filmy structure.

2. An element according to claim 1, **characterized in that** it comprises a heatable part in the filmy structure.

3. An element according to claim 2, **characterized in that** in said element the heatable part is arranged so as to be heated through electrical resistance and/or inductively coupled current.

4. An element according to claim 1, **characterized in that** it comprises a coolable part in the filmy structure.

5. An element according to claim 4, **characterized in that** in said element the coolable part is arranged so as to be a Peltier element integrated on a substrate.

6. An element according to claim 1, **characterized in that** in said element the filmy structure is substantially transparent.

7. An element according to claim 1, **characterized in that** it comprises in a filmy structure a thin film and/or thick film arranged so as to vary its temperature by means of an electric current traveling through the filmy structure part.

8. An element according to claim 1, **characterized in that** in said element said film thickness is matches to at least one of the following film thicknesses: less than 100 nm, less than 50 nm, less than 25 nm, less than 13 nm

9. An element according to claim 1, **characterized in that** in said element it further comprises integrated on a substrate an electrical switch component for coupling electric power to the electrically conductive filmy structure.

10. An element according to claim 1, **characterized in that** in said element it has an antenna structure and/or a means for using an electrically conductive filmy structure as an antenna and/or part thereof.

11. An element according to claim 1, **characterized in that** it comprises a first film structure and a second film structure for achieving a first thermal effect and for achieving a second thermal effect.

12. An element according to any one of claims 1 to 11, **characterized in that** in said element the substrate of the element is one of the following: plastic, paper, textile, fabric, glass, ceramic, stone, metal, pigment or a combination of any of the above.

13. Use of an element to achieve a thermal effect on a surface, when the element is an element according to claim 1.

14. Use according to claim 13, **characterized in that** said surface is a part of an antenna of a radar.

15. Use according to claim 13, **characterized in that** said surface is a part of a vehicle.

16. Use according to claim 13, **characterized in that** said surface is a surface of a part of a building.

17. Use according to claim 15 or 16, **characterized in that** said surface is a window surface.

18. Use according to claim 15 or 16, **characterized in that** said surface is a decorative surface.

19. A window structure, **characterized in that** it comprises an element according to claim 1 for producing a thermal effect.

20. A window structure according to claim 19, **characterized in that** it includes a first sub-layer and a second sub-layer so that said first sub-layer is isolated from said second sub-layer, but said first sub-layer comprises an element according to claim 1 arranged in the form of a first coil, and said second sub-layer comprises an element according to claim 1 arranged in the form of a second coil for inductively supplying electric power to said first coil.

21. A window structure according to claim 19, **characterized in that** the thermal effect for said window structure is one of the following: heating, cooling, holding the temperature, alternation of heating and cooling.

## Patentansprüche

1. Element, **dadurch gekennzeichnet, dass** das Element eine elektrisch leitende hauchdünne Struktur mit einer gewissen Dicke aufweist, wobei die hauchdünne Struktur keine Partikel mit einem größeren Durchmesser als 30 Nanometer enthält und auf einem Substrat mit Hochqualitätsplasma enthaltendem Material hergestellt wurde, das kalt von einem Abtragziel abgetragen wurde, um mittels elektrischem Strom, der mit der hauchdünnen Struktur gekoppelt wird, eine Heiz- oder Kühlwirkung in der hauchdünnen Struktur zu erzielen.

2. Element nach Anspruch 1, **dadurch gekennzeichnet, dass** es einen heizbaren Teil in der hauchdünnen Struktur aufweist.

3. Element nach Anspruch 2, **dadurch gekennzeichnet, dass** der heizbare Teil in dem Element derart eingerichtet ist, dass er durch Strom geheizt wird, der durch den elektrischen Widerstand und/oder induktiv gekoppelt wird.

4. Element nach Anspruch 1, **dadurch gekennzeichnet, dass** es einen kühlbaren Teil in der hauchdünnen Struktur aufweist.

5. Element nach Anspruch 4, **dadurch gekennzeichnet, dass** der kühlbare Teil in dem Element derart eingerichtet ist, dass er ein auf einem Substrat integriertes Peltierelement ist.

6. Element nach Anspruch 1, **dadurch gekennzeichnet, dass** in dem Element die hauchdünne Struktur im Wesentlichen transparent ist.

7. Element nach Anspruch 1, **dadurch gekennzeichnet, dass** es in einer hauchdünnen Struktur einen Dünnfilm und/oder Dickfilm aufweist, der derart eingerichtet ist, dass er seine Temperatur mit Hilfe eines elektrischen Stroms, der durch den hauchdünnen Strukturteil läuft, ändert.

8. Element nach Anspruch 1, **dadurch gekennzeichnet, dass** die Filmdicke in dem Element mit wenigstens einer der folgenden Filmdicken übereinstimmt: weniger als 100 nm, weniger als 50 nm, weniger als 25 nm, weniger als 13 nm.

9. Element nach Anspruch 1, **dadurch gekennzeichnet, dass** das Element ferner eine auf einem Substrat integrierte elektrische Schalterkomponente zum Koppeln elektrischer Leistung mit der elektrisch leitenden hauchdünnen Struktur aufweist.

10. Element nach Anspruch 1, **dadurch gekennzeichnet, dass** das Element eine Antennenstruktur und/oder ein Mittel zum Verwenden einer elektrisch leitenden hauchdünnen Struktur als eine Antenne und/oder einen Teil davon hat.

11. Element nach Anspruch 1, **dadurch gekennzeichnet, dass** es eine erste Filmstruktur und eine zweite Filmstruktur aufweist, um einen ersten thermischen Effekt zu erreichen und einen zweiten thermischen Effekt zu erreichen.

12. Element nach einem der Ansprüche 1 bis 11, **dadurch gekennzeichnet, dass** in dem Element das Substrat des Elements eines der folgenden ist: Kunststoff, Papier, Stoff, Gewebe, Glas, Keramik, Stein, Metall, Pigment oder eine Kombination beliebiger der vorstehenden.

13. Verwendung eines Elements, um einen thermischen Effekt auf einer Oberfläche zu erzielen, wenn das Element ein Element nach Anspruch 1, ist.

14. Verwendung nach Anspruch 13, **dadurch gekennzeichnet, dass** die Oberfläche ein Teil einer Antenne eines Radars ist.

15. Verwendung nach Anspruch 13, **dadurch gekennzeichnet, dass** die Oberfläche ein Teil eines Fahrzeugs ist.

16. Verwendung nach Anspruch 13, **dadurch gekennzeichnet, dass** die Oberfläche eine Oberfläche eines Gebäudeteils ist.

17. Verwendung nach Anspruch 15 oder 16, **dadurch gekennzeichnet, dass** die Oberfläche eine Fensterfläche ist.

18. Verwendung nach Anspruch 13, **dadurch gekennzeichnet, dass** die Oberfläche eine dekorative Oberfläche ist.

19. Fensterstruktur, **dadurch gekennzeichnet, dass** sie ein Element nach Anspruch 1 aufweist, um einen thermischen Effekt zu erzeugen.

20. Fensterstruktur, **dadurch gekennzeichnet, dass** sie eine erste Teilschicht und eine zweite Teilschicht aufweist, so dass die erste Teilschicht gegen die zweite Teilschicht isoliert ist, aber die erste Teilschicht ein Element nach Anspruch 1 aufweist, das in der Form einer ersten Spule eingerichtet ist, und die zweite Teilschicht ein Element nach Anspruch 1 aufweist, das in der Form einer zweiten Spule eingerichtet ist, um induktiv elektrische Leistung mit der ersten Spule zu koppeln.

21. Fenster nach Anspruch 19, **dadurch gekennzeichnet, dass** der thermische Effekt für die Fensterstruktur einer der folgenden ist: Heizen, Kühlen, Halten der Temperatur, Abwechseln von Heizen und Kühlen.

## Revendications

1. Elément, **caractérisé en ce que** l'élément comprend une structure pelliculaire conductrice de l'électricité d'une certaine épaisseur, laquelle structure pelliculaire ne contient pas de particules d'un diamètre supérieur à 30 nanomètres et a été produite sur un substrat avec un plasma de haute qualité contenant un matériau froid retiré d'une cible d'ablation, afin de d'obtenir un effet de chauffage ou de refroidissement dans la structure pelliculaire au moyen d'un courant électrique couplé à la structure pelliculaire.

2. Elément selon la revendication 1, **caractérisé en ce qu'**il comprend une partie apte à être chauffée dans la structure pelliculaire.

3. Elément selon la revendication 2, **caractérisé en ce que**, dans ledit élément, la partie apte à être chauffée conçue de façon à être chauffée par une résistance électrique et/ou un courant couplé de manière inductive.

4. Elément selon la revendication 1, **caractérisé en ce qu'**il comprend une partie apte à être refroidie dans la structure pelliculaire.

5. Elément selon la revendication 4, **caractérisé en ce que**, dans ledit élément, la partie apte à être refroidie est conçue de façon à être un élément Peltier intégré sur un substrat.

6. Elément selon la revendication 4, **caractérisé en ce que**, dans ledit élément, la structure pelliculaire est essentiellement transparente.

7. Elément selon la revendication 1, **caractérisé en ce qu'**il comprend, dans une structure pelliculaire, un film mince et/ou un film épais conçu de façon que sa température varie sous l'effet d'un courant électrique circulant à travers la partie structure pelliculaire.

8. Elément selon la revendication 1, **caractérisé en ce que**, dans ledit élément, ladite épaisseur de film correspond à au moins l'une des épaisseurs de film suivantes : moins de 100 nm, moins de 50 nm, moins de 25 nm, moins de 13 nm.

9. Elément selon la revendication 1, **caractérisé en ce que**, dans ledit élément, il comprend en outre, intégré sur un substrat, un composant interrupteur électrique pour permettre le couplage de l'énergie électrique à la structure pelliculaire conductrice de l'électricité.

10. Elément selon la revendication 1, **caractérisé en ce que**, dans ledit élément, il a une structure d'antenne et/ou des moyens pour utiliser une structure pelliculaire conductrice de l'électricité en tant qu'antenne et/ou partie d'antenne.

11. Elément selon la revendication 1, **caractérisé en ce qu'**il comprend une première structure pelliculaire et une deuxième structure pelliculaire pour permettre l'obtention d'un premier effet thermique et pour permettre l'obtention d'un deuxième effet thermique.

12. Elément selon l'une quelconque des revendications 1 à 11, **caractérisé en ce que**, dans ledit élément, le substrat de l'élément est l'un des matériaux suivants : plastique, papier, textile, tissu, verre, céramique, pierre, métal, pigment, ou une combinaison d'un ou plusieurs quelconques de ceux-ci.

13. Utilisation d'un élément pour obtenir un effet thermique sur une surface, lorsque l'élément est un élément selon la revendication 1.

14. Utilisation selon la revendication 13, **caractérisée en ce que** ladite surface est une partie d'une antenne de radar.

15. Utilisation selon la revendication 13, **caractérisée en ce que** ladite surface est une partie d'un véhicule.

16. Utilisation selon la revendication 13, **caractérisée en ce que** ladite surface est une surface d'une partie d'un bâtiment.

17. Utilisation selon la revendication 15 ou 16, **caractérisée en ce que** ladite surface est une surface de fenêtre.

18. Utilisation selon la revendication 15 ou 16, **caractérisée en ce que** ladite surface est une surface décorative.

19. Structure de fenêtre, **caractérisée en ce qu'**elle comprend un élément selon la revendication 1 pour produire un effet thermique.

20. Structure de fenêtre selon la revendication 19, **caractérisée en ce qu'**elle comprend une première sous-couche et une deuxième sous-couche, de telle sorte que ladite première sous-couche soit isolée de ladite deuxième sous-couche, mais ladite première sous-couche comprend un élément selon la revendication 1, conçu sous la forme d'une première bobine, et ladite deuxième sous-couche comprend un élément selon la revendication 1, conçu sous la forme d'une deuxième bobine pour permettre l'alimentation inductive de ladite première bobine en énergie électrique.

21. Structure de fenêtre selon la revendication 19, **caractérisée en ce que** l'effet thermique pour ladite structure de fenêtre est l'un des effets suivants : chauffage, refroidissement, maintien de la température, alternance de chauffage et refroidissement.
